(19) Europäisches Patentamt
European Patent Office
Office européen des brevets

(11) **EP 2 692 520 A1**

(12) **EUROPEAN PATENT APPLICATION**
published in accordance with Art. 153(4) EPC

(43) Date of publication:
   **05.02.2014 Bulletin 2014/06**

(21) Application number: **12762767.7**

(22) Date of filing: **29.03.2012**

(51) Int Cl.:
   **B32B 9/00** (2006.01)    **C23C 14/34** (2006.01)

(86) International application number:
   **PCT/JP2012/058477**

(87) International publication number:
   **WO 2012/133703 (04.10.2012 Gazette 2012/40)**

(84) Designated Contracting States:
   **AL AT BE BG CH CY CZ DE DK EE ES FI FR GB GR HR HU IE IS IT LI LT LU LV MC MK MT NL NO PL PT RO RS SE SI SK SM TR**

(30) Priority: **31.03.2011 JP 2011081283**

(71) Applicant: **Mitsubishi Plastics, Inc.**
   **Tokyo 100-8252 (JP)**

(72) Inventors:
   • **AMANAI, Hidetaka**
     **Ushiku-shi**
     **Ibaraki 300-1201 (JP)**
   • **MIYAZAKI, Makoto**
     **Ushiku-shi**
     **Ibaraki 300-1201 (JP)**

(74) Representative: **HOFFMANN EITLE**
   **Patent- und Rechtsanwälte**
   **Arabellastrasse 4**
   **81925 München (DE)**

(54) **GAS BARRIER LAMINATE FILM, AND METHOD FOR PRODUCING SAME**

(57)    To provide a gas barrier laminate film containing a substrate film having on at least one surface thereof one layer or plural layers of an inorganic thin film layer, a first layer of the inorganic thin film layer on a side of the substrate film being formed by a facing target sputtering method, and a method for producing a gas barrier laminate film, containing forming one layer or plural layers of an inorganic thin film layer on at least one surface of a substrate film, a first layer of the inorganic thin film layer on a side of the substrate film being formed by a facing target sputtering method, and thus to provide a gas barrier laminate film with high gas barrier property having a dense inorganic thin film layer that inflicts less damage to a substrate film, particularly to a resin film, on which the inorganic thin film layer is formed, and a method for producing the same.

EP 2 692 520 A1

**Description**

Technical Field

The present invention relates to a gas barrier laminate film, which is used as a package for preventing denaturation of foods, industrial articles, medical drugs and the like, a liquid crystal display device, an inorganic solar cell, an electromagnetic wave shield, a touch-sensitive panel, a color filter, a vacuum heat insulator, and an organic device, such as an organic EL (electroluminescence) device, an organic solar cell and an organic TFT, and a method for producing the same.

Background Art

A gas barrier plastic film containing a plastic film as a substrate having formed on the surface thereof an inorganic thin film is widely used as a package for an article that is necessarily shielded from various types of gas, such as water vapor and oxygen, for example, as a package for preventing denaturation of foods, industrial articles, medical drugs and the like. For the gas barrier plastic film, in recent years, new applications are receiving attention, in addition to the package, for example, a liquid crystal display device, an inorganic solar cell, an electromagnetic wave shield, a touch-sensitive panel, a color filter, a vacuum heat insulator, and a transparent electroconductive sheet and a vacuum heat insulator used in an organic device, such as an organic EL device, an organic solar cell and an organic TFT.

In these fields, such proposals have been made that a high-performance gas barrier film of an inorganic material is coated by a vacuum vapor deposition method, a magnetron sputtering method, an RF sputtering method, a plasma CVD method, an ion plating method or the like (see, for example, Patent Documents 1 to 4).

However, plastic films obtained by these methods are still insufficient in gas barrier property.

Related Art Documents

Patent Documents

Patent Document 1
Japanese Patent No. 3,319,164

Patent Document 2
JP-A-2006-96046

Patent Document 3
JP-A-6-210790

Patent Document 4
JP-A-2009-101548

Summary of the Invention

Problems to be solved by the Invention

An object of the present invention is to provide a gas barrier laminate film with high gas barrier property having a dense inorganic thin film layer that inflicts less damage to a substrate film, particularly to a resin film, on which the inorganic thin film layer is formed, and a method for producing the same.

Means for solving the Problems

As a result of earnest investigations made by the present inventors, it has been found that the problems associated with the ordinary production methods are ascribable to the denseness of the film in the inorganic thin film layer and the damages on forming the film. Specifically, it has been found that in the case where the inorganic thin film layer is formed by a vacuum vapor deposition method, the denseness of the film is generally lower than by a sputtering method or a CVD method, and is insufficient as the film quality for exhibiting gas barrier property. Furthermore, it has also been found that damages on the substrate film by heat radiation from the vapor deposition source is a factor causing deterioration of the barrier capability. In the case where the film is formed by an ordinary sputtering method, e.g., a magnetron sputtering method or an RF sputtering method, or a plasma CVD method, although the film has high denseness, the substrate film is exposed directly to plasma, and thereby the barrier capability is deteriorated due to damages on the substrate film caused by the plasma. It is possible to lower the discharge electric power for film formation to reduce the damages by the plasma, but in this case, the film forming speed is considerably lowered, which causes a serious problem in productivity. In the case where the film is formed by an ion plating method, damages by the plasma and damages by the heat radiation may be suppressed by selecting the excitation source, but the substrate film is damaged by ions, electrons and X-ray subsidiarily formed by exciting the target, thereby deteriorating the barrier property.

On the other hand, in the case where the first layer of the inorganic thin film layer on the side of the substrate film is formed by a facing target sputtering method, an inorganic thin film layer having high denseness that is equivalent to the ordinary sputtering method is formed. Furthermore, the substrate film is prevented from being exposed directly to plasma, and thus the damages on the substrate film by the plasma on forming the film is largely reduced without lowering the film forming speed by decreasing the discharge electric power. Consequently, excellent gas barrier property is realized.

Accordingly, the present invention provides a gas barrier laminate film containing a substrate film having on at least one surface thereof one layer or plural layers of an inorganic thin film layer, a first layer of the inorganic thin film layer on a side of the substrate film being formed by a facing target sputtering method, and a method for producing a gas barrier laminate film, containing forming one layer or plural layers of an inorganic thin film layer on at least one surface of a substrate film, a first layer of the inorganic thin film layer on a side of the substrate film being formed by a facing target sputtering method.

Advantages of the Invention

The gas barrier laminate film of the present invention has an inorganic thin film layer that inflicts less damage to a substrate film and has high denseness, and thus has high gas barrier property.

Brief Description of the Drawing

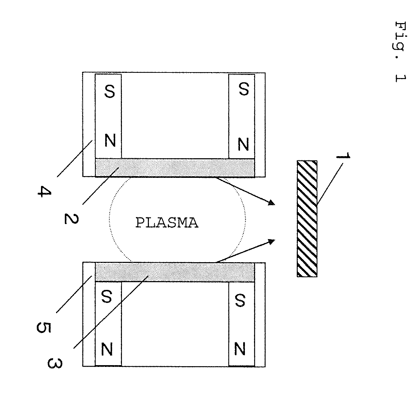

Fig. 1 is a schematic illustration showing an apparatus used for a facing target sputtering method.

Embodiments for carrying out the Invention

The present invention will be described in detail below. Gas Barrier Laminate Film
The gas barrier laminate film of the present invention contains a substrate film having on at least one surface thereof one layer or plural layers of an inorganic thin film layer, and the first layer of the inorganic thin film layer on the side of the substrate film is formed by a facing target sputtering method.

Substrate Film

The substrate film of the gas barrier laminate film of the present invention is preferably a transparent polymer film, and a thermoplastic polymer film is more preferred in this point of view. The raw material used therefor may be any resin that is used for an ordinary packaging material without particular limitation. Specific examples thereof include a polyolefin, such as a homopolymer or a copolymer of ethylene, propylene, butene and the like; an amorphous polyolefin, such as a cyclic polyolefin; a polyester, such as polyethylene terephthalate and polyethylene 2,6-naphthalate; a polyamide, such as nylon 6, nylon 66, nylon 12 and copolymer nylon; polyvinyl alcohol, an ethylene-vinyl acetate copolymer partial hydrolysate (EVOH), a polyimide, a polyetherimide, a polysulfone, a polyethersulfone, a polyether ether ketone, a polycarbonate, a polyvinyl butyral, a polyarylate, a fluorine resin, an acrylate resin and a biodegradable resin. Among these, a polyester, a polyamide, a polyolefin and a biodegradable resin are preferred from the standpoint of the film strength, the cost and the like.
The substrate film may contain known additives, such as an antistatic agent, a light shielding agent, an ultraviolet ray absorbent, a plasticizer, a lubricant, a filler, a colorant, a stabilizer, a lubricating agent, a crosslinking agent, an antiblocking agent and an antioxidant.
The thermoplastic polymer film as the substrate film is molded by using the aforementioned raw material, and the film may be unstretched or stretched on using as the substrate. The film may be laminated on any other plastic substrate. The substrate film may be produced by a known method, and for example, a raw material resin is melted and extruded through a circular die or a T-die with an extruder, and then quenched, thereby producing an unstretched film, which is substantially amorphous and unoriented. The unstretched film is then stretched in the machine direction (longitudinal direction) of the film or the direction perpendicular to the machine direction (transverse direction) of the film by a known method, such as uniaxial stretching, tenter sequential biaxial stretching, tenter simultaneous biaxial stretching, and tubular simultaneous biaxial stretching, thereby producing a film having been stretched in at least one direction.

The thickness of the substrate film may be generally selected from a range of from 5 to 500 $\mu$m, and preferably from 10 to 200 $\mu$m, depending on the application thereof in consideration of the mechanical strength, the flexibility, the transparency and the like as the substrate of the gas barrier laminate film of the present invention, and a sheet material having a large thickness is also included. The width and length of the film are not particularly limited, and may be appropriately selected depending on the application thereof.

Inorganic Thin Film Layer

Examples of the inorganic substance that constitutes the inorganic thin film layer include compounds containing a typical metal or a 3d transition metal with oxygen, nitrogen or carbon, for example, silicon, aluminum, magnesium, zinc, tin, nickel, titanium, indium, gallium and the like, or oxides, carbides and nitrides thereof and mixtures thereof. From the standpoint of maintenance of high gas barrier property stably, preferred examples thereof include compounds containing a typical metal or a 3d transition metal with oxygen and/or nitrogen, and more preferred examples thereof include silicon compounds containing oxygen and/or nitrogen, and aluminum oxide. Among these, silicon oxide, silicon nitride and aluminum oxide are particularly preferred. In addition to the inorganic substances, a carbonaceous substance, such as diamond-like carbon, may also be used.

The material for constituting the first layer of the inorganic thin film layer on the side of the substrate film (which may be hereinafter referred to as an "underlayer") is preferably, for example, a silicon compound containing oxygen and nitrogen ($SiO_xN_y$) or aluminum oxide ($AlO_z$), and particularly preferably aluminum oxide ($AlO_z$), from the standpoint of the gas barrier property and the adhesion to the substrate film.

Herein, numerals x and y satisfy $0 \leq x \leq 2.0$, $0 \leq y \leq 1.3$ and $0 \leq x/2.0 + y/1.3 \leq 1$, and y is preferably from 0.1 to 1.3, and more preferably from 0.5 to 1.1. Numeral z satisfies $0 \leq z \leq 1.5$ and is preferably from 1 to 1.5, and more preferably 1.2 to 1.5.

The thickness of the entire inorganic thin film layer is generally from 1 to 1,000 nm, preferably from 10 to 500 nm, more preferably from 10 to 300 nm, and most preferably from 10 to 150 nm.

The thickness of the underlayer is generally from 0.1 to 500 nm, and higher gas barrier property may be obtained with a smaller thickness in some cases. In such cases, the thickness is preferably from 0.1 to 200 nm, more preferably from 0.1 to 100 nm, particularly preferably from 0.1 to 50 nm, and most preferably from 0.1 to 25 nm.

When the thickness is in the range, sufficient gas barrier property may be obtained, cracks and delamination may not occur in the thin film, and excellent transparency may be obtained.

The inorganic thin film layer is formed with one layer or plural layer on the substrate film, and for realizing better gas barrier property, preferably formed with plural layers.

In this case, the method for producing the second and higher layers from the side of the substrate film, i.e., the other layers than the underlayer, is not particularly limited, and the layers may be formed by various methods, for example, a chemical vapor deposition method and a physical vapor deposition method, such as a vacuum vapor deposition method, a magnetron sputtering method, an RF sputtering method, a plasma CVD method, an ion plating method, a facing target sputtering method and a catalytic chemical vapor deposition method.

It is preferred that the plural layers of the inorganic thin film layer are formed continuously in an inert gas atmosphere or in vacuum without exposure to the air, and thereby the gas barrier property may be enhanced as compared to the case where the layers are formed discontinuously. It is considered that this is because excessive oxidation or inactivation of the surface due to the components of the air may not occur.

The layer formed on the first layer on the side of the substrate film (i.e., the underlayer) is not particularly limited, and a layer formed by a non-plasma forming method, such as a vacuum vapor deposition method and a catalytic chemical vapor deposition (Cat-DVD) method, is preferred since the underlayer and the other inorganic thin film layers are not damaged with plasma. A layer formed by a vacuum vapor deposition method is preferred from the standpoint of the productivity since the inorganic thin film layer having a sufficient thickness may be formed in a short period of time due to the large film forming rate. The vacuum vapor deposition method is more preferably a vacuum heating vapor deposition method. The Cat-CVD method is preferred since a dense film may be obtained.

The Cat-CVD method is performed with a catalytic chemical vapor deposition apparatus, in which a metal catalyst wire as a heating catalyst is heated in vacuum, and a material gas is subjected to catalytic decomposition by making in contact with the metal catalyst wire, thereby forming a thin film containing the elements constituting the raw material gas as the major skeleton substance on a substrate film.

The layer formed on the underlayer by a vacuum vapor deposition method or a catalytic chemical vapor deposition method is preferably a layer formed of a silicon compound containing oxygen and/or nitrogen, and particularly preferably a layer formed of silicon oxide, from the standpoint of the durability, such as the heat and humidity resistance and the corrosion resistance.

The inorganic thin film layer formed by a vacuum vapor deposition method or a catalytic chemical vapor deposition method is preferably the uppermost layer most remote from the substrate among the continuous plural layers constituting the inorganic thin film layer since the aforementioned advantages may be highly obtained. The upper most layer most remote from the substrate in the case, for example, of the inorganic thin film layer having a constitution of (inorganic plural layers 1) / (organic layer) / (inorganic plural layers 2) means the upper most layers of each of the inorganic plural layers 1 and the inorganic plural layers 2.

Film Forming Method

in the present invention, the underlayer of the inorganic thin film layer is formed by a facing target sputtering method (FTS method).

The FTS method forms a film by using an apparatus having a sputtering target and a film forming substrate that are disposed perpendicularly (see, for example, JP-A-2007-23304, paragraphs (0051) to (0053) and Fig. 3), and as shown in Fig. 1, targets 2 and 3 are made to face each other in an apparatus, to which a gas is charged, and a magnetic field is formed with an electrode (anode) 4 and an electrode (cathode) 5, thereby forming a plasma atmosphere (which is surrounded by the broken line). The targets are sputtered in the atmosphere, and thereby the inorganic material thus flown is deposited on the surface of the substrate film 1 to form the inorganic thin film layer.

In the FTS method, the plasma is confined in the region between the targets, and thus the substrate is not exposed directly to the plasma or secondary electrons. As a result, the film may be formed with less damage, and furthermore, a dense thin film may be formed as similar to the ordinary sputtering method. The use of the FTS method realizes the formation of a dense inorganic thin film layer with suppressed damage on the substrate film, on which the inorganic thin film layer is formed, and thus is suitable as a thin film forming method for a barrier film.

The conditions of the FTS method employed in the present invention may be appropriately selected depending on the situation, and it is preferred that the film forming pressure is from 0.1 to 1 Pa, the electric power is from 0.5 to 10 kW, the frequency is from 1 to 1,000 kHz, and the pulse width is preferably from 1 to 1,000 $\mu$sec. When the conditions are in the ranges, the barrier film thus formed may have sufficient gas barrier property, cracks and delamination may not occur on forming the film, and excellent transparency may be obtained.

The introduced gas, such as Ar, $N_2$ and $O_2$, may be controlled for the introducing rates by the film forming pressure, and the flow rate ratio of Ar, $N_2$ and $O_2$ may be controlled to provide the desired composition for the layer to be formed.

Anchor Coating Layer

In the present invention, an anchor coating layer is preferably provided by coating an anchor coating agent between the substrate film and the underlayer, for enhancing the adhesion between the substrate film and the inorganic thin film layer. Examples of the anchor coating agent in view of the productivity include a polyester resin, a urethane resin, an acrylic resin, a nitrocellulose resin, a silicone resin, a vinyl alcohol resin, a polyvinyl alcohol resin, an ethylene-vinyl alcohol resin, a modified vinyl resin, an isocyanate group-containing resin, a carbodiimide resin, an alkoxy group-containing resin, an epoxy resin, an oxazoline resin, a modified styrene resin, a modified silicone resin, an alkyl titanate resin and a poly-p-xylylene resin, which may be used solely or as a combination of two or more kinds thereof.

The thickness of the anchor coating layer provided on the substrate film is generally from 0.1 to 5, 000 nm, preferably from 1 to 2,000 nm, and more preferably from 1 to 1,000 nm. When the thickness is in the range, good lubricating property may be obtained, delamination of the anchor coating layer from the substrate due to internal stress in the anchor coating layer may substantially not occur, a uniform thickness may be maintained, and excellent adhesion between the layers may be obtained.

For enhancing the coating property and the adhesion property of the anchor coating agent to the substrate film, the substrate film may be subjected to an ordinary surface treatment, such as a chemical treatment and a discharge treatment, before coating the anchor coating agent.

Constitution of Gas Barrier Laminate Film

The gas barrier laminate film of the present invention may preferably have the following embodiments from the standpoint of the gas barrier property and the adhesion property.

In the following description the expression (A) / (B) / (C) means that A, B and C are laminated in this order from the bottom (or the top).

(1) (substrate film) / (FTS inorganic thin film layer)
(2) (substrate film) / (FTS inorganic thin film layer) / (vapor-deposited inorganic thin film layer)
(3) (substrate film) / (FTS inorganic thin film layer) / (FTS inorganic thin film layer)
(4) (substrate film) / (AC) / (FTS inorganic thin film layer)
(5) (substrate film) / (AC) / (FTS inorganic thin film layer) / (vapor-deposited inorganic thin film layer)
(6) (substrate film) / (AC) / (FTS inorganic thin film layer) / (FTS inorganic thin film layer)

The (AC) means the anchor coating layer, the (FTS inorganic thin film layer) means the inorganic thin film layer formed by an FTS method, and the (vapor-deposited inorganic thin film layer) means the inorganic thin film layer formed by a physical vapor deposition method, and preferably a vacuum vapor deposition method. The (vapor-deposited inorganic thin film layer) may also be an inorganic thin film layer formed by a catalytic chemical vapor deposition method.

The gas barrier laminate film of the present invention thus obtained is excellent in gas barrier property, and thus may have a moisture permeability under conditions of 40°C and 90%RH of 0.3 $g/m^2$/day or less, further 0.1 $g/m^2$/day or less, and still further 0.05 $g/m^2$/day or less.

As the gas barrier laminate film of the present invention is excellent in transparency without forming cracks and delamination occurring in the thin film, the gas barrier laminate film may be used as any application, for example, a package for preventing denaturation of foods, industrial articles, medical drugs and the like, a liquid crystal display device, an inorganic solar cell, an electromagnetic wave shield, a touch-sensitive panel, a color filter, a vacuum heat insulator, and an organic device, such as an organic EL device, an organic solar cell and an organic TFT, and may be particularly preferably used as a protective sheet for an electronic device, such as a liquid crystal display device, a solar cell, an organic device and a vacuum heat insulator.

Example

The present invention will be described in more detail with reference to examples below, but the present invention is not limited to the examples. The gas barrier films obtained in the examples were evaluated for capabilities in the following manners.

Water Vapor Permeability

The water vapor permeability was evaluated in the following manner according to the conditions of JIS Z0222, test method for moisture permeability for moisture proof packaging container, and JIS Z0208, test method for moisture permeability for moisture proof packaging material (cup method).

Two sheets of the gas barrier laminate films each having a moisture permeation area of a square of 10.0 cm × 10.0 cm were used, and a bag having been sealed on the four edges thereof containing approximately 20 g of anhydrous calcium chloride as a desiccant was produced therewith. After placing the bag in a constant temperature and humidity chamber at a temperature of 40°C and a relative humidity of 900, the mass thereof was measured (by 0.1 mg) with an interval of 48 hours or more for 6.9 days, which was a rough period where the weight increment reached constant, and the water vapor permeability was calculated from the following expression.

```
water vapor permeability (g/m2/day) = (m/s)/t
```

m: mass increment between the last two weight measurements in the test period (g)
s: moisture permeation area ($m^2$)
t: period of time between the last two weight measurements in the test period (day) / 5.97 (day)

Control of Thickness of Inorganic Thin Film Layer formed by FTS Method

For the thickness of the inorganic thin film, single layer thin films formed under various conditions in advance were measured with a step gauge, and the film forming speeds under the conditions were calculated from the film forming time and the thickness. Thereafter, the film was formed while controlling the film forming time based on the film forming speed under the film forming condition, thereby controlling the thickness of the inorganic thin film layer.

Measurement of Thickness of Inorganic Thin Film Layer formed by PVD Method

The thickness of the inorganic thin film was measured with a fluorescent X-ray. This method utilizes the phenomenon that an atom irradiated with an X-ray radiates a fluorescent X-ray that is characteristic of the atom, and the number of atoms (i.e., the amount thereof) may be obtained by measuring the intensity of the fluorescent X-ray radiated. Specifically, thin films with two known thicknesses were formed on a film and measured respectively for the intensity of the characteristic fluorescent X-ray thus radiated, and a calibration curve was produced from the resulting information. A specimen to be measure was then measured similarly for the intensity of the fluorescent X-ray, and the thickness thereof was measured from the calibration curve.

In the following description, the layer such as the underlayer describe above may be referred to as a film, such as an $SiO_xN_y$ film, in some cases.

Example 1

A polyethylene naphthalate film having a thickness of 12 $\mu$m (Q51C, produced by Teijin DuPont Films Japan Ltd.) was used as the substrate film, and on a corona treated surface thereof, a mixture obtained by mixing an isocyanate compound (Coronate L, produced by Nippon Polyurethane Industry Co., Ltd.) and a saturated polyester (Vylon 300, produced by Toyobo Co., Ltd., number average molecular weight: 23,000) at a mass ratio of 1/1 was coated and dried to form an anchor coating layer having a thickness of 0.1 $\mu$m.

Subsequently, an $SiO_xN_y$ film having a thickness of 50 nm was formed on the anchor coating layer by an FTS method under conditions of a film forming pressure of 0.3 Pa, an electric power of 2, 000 W, a frequency of 100 kHz and a pulse width of 4 $\mu$sec, thereby providing a laminate film. The laminate film thus obtained was evaluated in the aforementioned manners. The results obtained are shown in Table 1.

The evaluation of the composition of the resulting $SiO_xN_y$ film by an XPS method revealed x = 0.20 and y = 0.99.

Example 2

A laminate film was obtained in the same manner as in Example 1 except that an $SiO_x$ vacuum vapor deposition film (PVD film) having a thickness of 50 nm was formed on the $SiO_xN_y$ film with a vacuum vapor deposition apparatus by evaporating SiO in vacuum of 2 x $10^{-3}$ Pa. The laminate film thus obtained was evaluated in the aforementioned manners. The results obtained are shown in Table 1.

Example 3

A laminate film was obtained in the same manner as in Example 2 except that the thickness of the $SiO_xN_y$ film was changed to 10 nm. The laminate film thus obtained was evaluated in the aforementioned manners. The results obtained are shown in Table 1.

Example 4

A laminate film was obtained in the same manner as in Example 1 except that an $AlO_z$ film having a thickness of 50 nm was formed by an FTS method under the conditions shown in Table 1, instead of the $SiO_xN_y$ film. The laminate film thus obtained was evaluated in the aforementioned manners. The results obtained are shown in Table 1.

The evaluation of the composition of the resulting $AlO_z$ film by an XPS method revealed z = 1.25.

Example 5

A laminate film was obtained in the same manner as in Example 2 except that an $AlO_z$ film having a thickness of 100 nm was formed by an FTS method under the conditions shown in Table 1, instead of the $SiO_xN_y$ film, and an $SiO_x$ vacuum vapor deposition film (PVD film) having a thickness of 30 nm was formed thereon. The laminate film thus obtained was evaluated in the aforementioned manners. The results obtained are shown in Table 1.

Example 6

A laminate film was obtained in the same manner as in Example 5 except that the thickness of the $AlO_z$ film was changed to 50 nm, and the thickness of the $SiO_x$ vacuum vapor deposition film (PVD film) was changed to 50 nm. The laminate film thus obtained was evaluated in the aforementioned manners. The results obtained are shown in Table 1.

The evaluation of the composition of the resulting $AlO_z$ film by an XPS method revealed z = 1.25.

Example 7

A laminate film was obtained in the same manner as in Example 6 except that the thickness of the $AlO_z$ film was changed to 25 nm. The laminate film thus obtained was evaluated in the aforementioned manners. The results obtained are shown in Table 1.

Example 8

A laminate film was obtained in the same manner as in Example 5 except that the thickness of the $AlO_z$ film was changed to 10 nm. The laminate film thus obtained was evaluated in the aforementioned manners. The results obtained are shown in Table 1.

Example 9

A laminate film was obtained in the same manner as in Example 5 except that the formation of from the $AlO_z$ film to the PVD film was performed continuously in vacuum without exposure to the air. The laminate film thus obtained was evaluated in the aforementioned manners. The results obtained are shown in Table 1.
The evaluation of the composition of the resulting $AlO_z$ film by an XPS method revealed $z = 1.23$.

Example 10

A laminate film was obtained in the same manner as in Example 9 except that the thickness of the $AlO_z$ film was changed to 50 nm, an $SiO_x$ film having a thickness of 20 nm was formed thereon by a catalytic chemical vapor deposition (Cat-CVD) method under conditions of a film forming pressure of 100 Pa, an electric power supplied to the catalyst of 1.8 kW, an HMDS flow rate of 10 sccm and an $H_2$ flow rate of 1,000 sccm, and furthermore an $SiO_x$ vacuum vapor deposition film (PVD film) having a thickness of 30 nm was formed thereon. The laminate film thus obtained was evaluated in the aforementioned manners. The results obtained are shown in Table 1.

Example 11

A laminate film was obtained in the same manner as in Example 1 except that the thickness of the $SiO_xN_y$ film was changed to 10 nm, and an $AlO_z$ film was formed on the $SiO_xN_y$ film by an FTS method with the gas flow rates shown in Table 1 under conditions of a film forming pressure of 0.3 Pa, an electric power of 2,000 W, a frequency of 100 kHz and a pulse width of 2 $\mu$sec. The laminate film thus obtained was evaluated in the aforementioned manners. The results obtained are shown in Table 1.

Example 12

A laminate film was obtained in the same manner as in Example 2 except that the anchor coating layer was not formed, but the formation of the thin film by an FTS method and the later steps were performed directly on the substrate film. The laminate film thus obtained was evaluated in the aforementioned manners. The results obtained are shown in Table 1.

Comparative Example 1

The polyethylene naphthalate film used in Example 1 (Q51C, produced by Teijin DuPont Films Japan Ltd.) was evaluated in the aforementioned manners. The results obtained are shown in Table 1.

Comparative Example 2

A laminate film was obtained in the same manner as in Example 1 except that an $SiO_x$ vacuum vapor deposition film (PVD film) having a thickness of 50 nm was formed on the anchor coating layer with a vacuum vapor deposition apparatus by evaporating SiO in vacuum of $2 \times 10^{-3}$ Pa, instead of forming the $SiO_xN_y$ film. The laminate film thus obtained was evaluated in the aforementioned manners. The results obtained are shown in Table 1.

Reference Example 1

A polyethylene naphthalate film having a thickness of 12 $\mu$m (Q51C, produced by Teijin DuPont Films Japan Ltd.) was used as the substrate film, and on a corona treated surface thereof, a mixture obtained by mixing an isocyanate compound (Coronate L, produced by Nippon Polyurethane Industry Co., Ltd.) and a saturated polyester (Vylon 300, produced by Toyobo Co. , Ltd. , number average molecular weight: 23,000) at a mass ratio of 1/1 was coated and dried to form an anchor coating layer having a thickness of 0.1 $\mu$m.

An $SiO_x$ vacuum vapor deposition film (PVD film) having a thickness of 30 nm was formed on the anchor coating layer with a vacuum vapor deposition apparatus by evaporating SiO in vacuum of 2 x 10$^{-3}$ Pa.

An $AlO_z$ film having a thickness of 100 nm was formed on the PVD film by an FTS method under the conditions shown in Table 1, thereby providing a laminate film. The laminate film thus obtained was evaluated in the aforementioned manners. The results obtained are shown in Table 1.

Comparative Example 3

A laminate film was obtained in the same manner as in Example 4 except that an $AlO_z$ film having a thickness of 50 nm (ordinary sputtered film) was formed by an ordinary parallel flat plate DC magnetron sputtering method with the gas flow rates shown in Table 1 under conditions of a film forming pressure of 0.3 Pa, an electric power of 300 W, a voltage of 385 V, a electric current of 0.8 A and no bias applied, instead of the FTS method. The laminate film thus obtained was evaluated in the aforementioned manners. The results obtained are shown in Table 1.

Example 13

The anchor coating layer described in Example 1 was coated to a thickness of 0.05 $\mu$m on a polyethylene terephthalate  film having a thickness of 12 $\mu$m (a biaxially stretched PET film obtained by melt-extruding Novapex, produced by Mitsubishi Chemical Corporation, to form a sheet, and then stretching the sheet) to form a film, on which an $SiO_xN_y$ film having a thickness of 50 nm was formed by an FTS method under conditions of a film forming pressure of 0.3 Pa, an electric power of 2,000 W, a frequency of 100 kHz and a pulse width of 4 $\mu$sec, thereby providing a laminate film. The laminate film thus obtained was evaluated in the aforementioned manners. The results obtained are shown in Table 1.

Example 14

A laminate film was obtained in the same manner as in Example 13 except that an $SiO_x$ vacuum vapor deposition film (PVD film) having a thickness of 50 nm was formed on the $SiO_xN_y$ film with a vacuum vapor deposition apparatus by evaporating SiO in vacuum of 2 x 10$^{-3}$ Pa. The laminate film thus obtained was evaluated in the aforementioned manners. The results obtained are shown in Table 1.

Example 15

A laminate film was obtained in the same manner as in Example 14 except that the thickness of the $SiO_xN_y$ film was changed to 10 nm. The laminate film thus obtained was evaluated in the aforementioned manners. The results obtained  are shown in Table 1.

Example 16

A laminate film was obtained in the same manner as in Example 13 except that an $AlO_z$ film having a thickness of 50 nm was formed by an FTS method under the conditions shown in Table 1, instead of the $SiO_xN_y$ film. The laminate film thus obtained was evaluated in the aforementioned manners. The results obtained are shown in Table 1.

Example 17

A laminate film was obtained in the same manner as in Example 14 except that an $AlO_z$ film having a thickness of 50 nm was formed by an FTS method under the conditions shown in Table 1, instead of the $SiO_xN_y$ film. The laminate film thus obtained was evaluated in the aforementioned manners. The results obtained are shown in Table 1.

Example 18

A laminate film was obtained in the same manner as in Example 17 except that the thickness of the $AlO_z$ film was changed to 25 nm. The laminate film thus obtained was evaluated in the aforementioned manners. The results obtained are shown in Table 1.

Example 19

A laminate film was obtained in the same manner as in Example 13 except that the thickness of the $SiO_xN_y$ film was changed to 10 nm, and an $AlO_z$ film having a thickness of 50 nm was formed on the $SiO_xN_y$ film by an FTS method with the gas flow rates shown in Table 1 under conditions of a film forming pressure of 0.3 Pa, an electric power of 2,000 W, a frequency of 100 kHz and a pulse width of 2 $\mu$sec. The laminate film thus obtained was evaluated in the aforementioned manners. The results obtained are shown in Table 1.

Comparative Example 4

The film containing a polyethylene terephthalate film having an anchor coating layer used in Example 13 was evaluated in the aforementioned manners. The results obtained are shown in Table 1.

Comparative Example 5

A laminate film was obtained in the same manner as in Example 13 except that an $SiO_x$ vacuum vapor deposition film (PVD film) having a thickness of 50 nm was formed on the anchor coating layer with a vacuum vapor deposition apparatus by evaporating SiO in vacuum of $2 \times 10^{-3}$ Pa, instead of forming the $SiO_xN_y$ film. The laminate film thus obtained was evaluated in the aforementioned manners. The results obtained are shown in Table 1.

Table 1

| Example | Layer constitution | Thickness | | Conditions for formation of FTS film | | | | | | | | | | Water vapor permeability (g/m2/day) |
|---|---|---|---|---|---|---|---|---|---|---|---|---|---|---|
| | | FTS film (nm) | PVD film (nm) | Film forming pressure (Pa) | Electric power (W) | Voltage (V) | Current (A) | Frequency (kHz) | Pulse width (μsec) | Ar (sccm) | O2 (sccm) | N2 (sccm) | |
| Example 1 | PEN/AC/SiOxNy | 50 | - | 0.3 | 2,000 | 350 | 5.8 | 100 | 4 | 36 | 1 | 20 | 0.037 |
| Example 2 | PEN/AC/SiOxNy/PVD | 50 | 50 | do. | do. | do. | do. | do. | do. | do. | do. | do. | 0.020 |
| Example 3 | PEN/AC/SiOxNy/PVD | 10 | 50 | do. | do. | do. | do. | do. | do. | do. | do. | do. | 0.035 |
| Example 4 | PEN/AC/AlOz | 50 | 0 | do. | do. | 318 | 6.3 | do. | 2 | 40 | 25 | - | 0.016 |
| Example 5 | PEN/AC/AlOz/PVD | 100 | 30 | do. | do. | 315 | do. | do. | do. | 42 | do. | - | 0.007 |
| Example 6 | PEN/AC/AlOz/PVD | 50 | 50 | do. | do. | do. | do. | do. | do. | do. | do. | - | 0.008 |
| Example 7 | PEN/AC/AlOz/PVD | 25 | 50 | do. | do. | do. | do. | do. | do. | do. | do. | - | 0.003 |
| Example 8 | PEN/AC/AlOz/PVD | 10 | 30 | do. | do. | do. | do. | do. | do. | do. | do. | - | 0.002 |
| Example 9 | PEN/AC/AlOz/PVD (continuous in vacuum) | 100 | 30 | do. | 2,200 | 320 | 6.9 | do. | do. | 50 | 14 | - | 0.001 |
| Example 10 | PEN/AC/AlOz/Cat-CVD/PVD (continuous in vacuum) | 50 | 20 (Cat-CVD film)/30 (PVD film) | do. | do. | do. | do. | do. | do. | do. | do. | - | 0.002 |

(continued)

| | Layer constitution | Thickness | | Conditions for formation of FTS film | | | | | | | | | Water vapor permeability (g/m2/day) |
| | | FTS film (nm) | PVD film (nm) | Film forming pressure (Pa) | Electric power (W) | Voltage (V) | Current (A) | Frequency (kHz) | Pulse width ($\mu$sec) | Ar (sccm) | 02 (sccm) | N2 (sccm) | |
|---|---|---|---|---|---|---|---|---|---|---|---|---|---|
| Example 11 | PEN/AC/ SiOxNy/AlOz | 10/50 | - | do. | do. | 350/315 | 5.8/6.3 | do. | 4/2 | 36/42 | 1/25 | 20/- | 0.014 |
| Example 12 | PEN/ SiOxNy/PVD | 50 | 50 | do. | do. | 350 | 5.8 | do. | 4 | 36 | 1 | 20 | 0.180 |
| Comparative Example 1 | PEN | - | - | - | - | - | - | - | - | - | - | - | 4.612 |
| Comparative Example 2 | PEN/AC/PVD | - | 50 | - | - | - | - | - | - | - | - | - | 0.495 |
| Reference Example 1 | PEN/AC/PVD/ AlOz | 100 | 30 | 0.3 | 2,000 | 318 | 6.3 | 100 | 2 | 40 | 25 | - | 0.098 |
| Comparative Example 3 | PEN/AC/ ordinarily sputtered AlOz | 50 (ordinary sputtering) | - | 0.3 | 300 | 385 | 0.8 | - | - | 20 | 10 | - | 0.265 |
| Example 13 | PET/AC/ SiOxNy | 50 | - | 0.3 | 2,000 | 350 | 5.8 | 100 | 4 | 36 | 1 | 20 | 0.129 |
| Example 14 | PET/AC/ SiOxNy/PVD | 50 | 50 | do. | do. | do. | do. | do. | do. | do. | do. | do. | 0.125 |
| Example 15 | PET/AC/ SiOxNy/PVD | 10 | 50 | do. | do. | do. | do. | do. | do. | do. | do. | do. | 0.252 |
| Example 16 | PET/AC/AlOz | 50 | - | do. | do. | 315 | 6.3 | do. | 2 | 42 | 25 | - | 0.051 |
| Example 17 | PET/AC/ AlOz/PVD | 50 | 50 | do. | do. | do. | do. | do. | do. | do. | do. | do. | 0.050 |
| Example 18 | PET/AC/ AlOz/PVD | 25 | 50 | do. | do. | do. | do. | do. | do. | do. | do. | do. | 0.051 |
| Example 19 | PET/AC/ SiOxNy/AlOz | 10/50 | - | do. | do. | 350/315 | 5.8/6.3 | do. | 4/2 | 36/42 | 1/25 | 20/- | 0.106 |

| | Layer constitution | Thickness | | Conditions for formation of FTS film | | | | | | | | | | Water vapor permeability (g/m2/day) |
|---|---|---|---|---|---|---|---|---|---|---|---|---|---|---|
| | | FTS film (nm) | PVD film (nm) | Film forming pressure (Pa) | Electric power (W) | Voltage (V) | Current (A) | Frequency (kHz) | Pulse width ($\mu$sec) | Ar (sccm) | 02 (sccm) | N2 (sccm) | | |
| Comparative Example 4 | PET/AC | - | - | - | - | - | - | - | - | - | - | - | | 5.816 |
| Comparative Example 5 | PET/AC/PVD | - | 50 | - | - | - | - | - | - | - | - | - | | 1.080 |

Note:
PEN: polyethylene naphthalate
PET: polyethylene terephthalate
AC: anchor coating layer
Layer constitution: lower layer on left side, upper layer on right side
$SiO_xN_y$ and AlOz films: formed by FTS method (except for Comparative Example 3)
PVD film: formed by vacuum vapor deposition method

It has been apparent from the above that the gas barrier laminate films of Examples 1 to 19 having the constitutions according to the present invention had excellent gas barrier property. In particular, it has been apparent that the gas barrier laminate films of the present invention having the underlayer formed of aluminum oxide in the inorganic thin film layer or having plural inorganic thin film layers had further excellent gas barrier property.

On the other hand, the gas barrier laminate films of Comparative Examples 1 and 4 having no inorganic thin film layer, Comparative Examples 2 and 5 having, as the underlayer, the inorganic thin film layer formed by a vacuum vapor deposition method as being different from the present invention, and Comparative Example 3 having the inorganic thin film layer formed by the ordinary sputtering method as being different from the FTS method had insufficient gas barrier property. It is considered that this is because the underlayer has less denseness since the underlayer is formed by the PVD method or the ordinary sputtering method, or the substrate film is damaged by the heat radiation or the plasma.

Industrial Applicability

The gas barrier laminate film of the present invention may be preferably applied to a package for preventing denaturation of foods, industrial articles, medical drugs and the like, a liquid crystal display device, a solar cell, an electromagnetic wave shield, a touch-sensitive panel, a color filter, a vacuum heat insulator, and a protective sheet for an organic device, such as an organic EL device, an organic solar cell and an organic TFT.

Description of Symbols

1        substrate film
2, 3     target
4        electrode (anode)
5        electrode (cathode)


**Claims**

1.  A gas barrier laminate film comprising a substrate film having on at least one surface thereof one layer or plural layers of an inorganic thin film layer, a first layer of the inorganic thin film layer on a side of the substrate film being formed by a facing target sputtering method.

2.  The gas barrier laminate film according to claim 1, wherein the first layer of the inorganic thin film layer on a side of the substrate film is a layer containing a compound containing a typical metal or a 3d transition metal with oxygen and/or nitrogen.

3.  The gas barrier laminate film according to claim 1, wherein the first layer of the inorganic thin film layer on a side of the substrate film is a layer containing a silicon compound containing oxygen and/or nitrogen, or aluminum oxide.

4.  The gas barrier laminate film according to claim 1, which contains plural layers of the inorganic thin film layers.

5.  The gas barrier laminate film according to any one of claims 1 to 4, wherein an inorganic thin film layer is formed on the first layer on a side of the substrate film by a vacuum vapor deposition method or a catalytic chemical vapor deposition method.

6.  The gas barrier laminate film according to claim 5, wherein the inorganic thin film layer formed by a vacuum vapor deposition method or a catalytic chemical vapor deposition method is a layer containing a silicon compound containing oxygen and/or nitrogen.

7.  The gas barrier laminate film according to claim 5 or 6, wherein the inorganic thin film layer formed by a vacuum vapor deposition method or a catalytic chemical vapor deposition method is the uppermost layer most remote from the substrate among continuous plural layers constituting the inorganic thin film layer.

8.  The gas barrier laminate film according to any one of claims 1 to 7, wherein the plural layers of the inorganic thin film layer are formed continuously in an inert gas atmosphere or in vacuum without exposure to the air.

9. The gas barrier laminate film according to any one of claims 1 to 8, wherein the first layer of the inorganic thin film layer on a side of the substrate film has a thickness of from 0.1 to 500 nm.

10. The gas barrier laminate film according to any one of claims 1 to 8, wherein the first layer of the inorganic thin film layer on a side of the substrate film has a thickness of from 0.1 to 50 nm.

11. The gas barrier laminate film according to any one of claims 1 to 10, which has an anchor coating layer between the substrate film and the first layer of the inorganic thin film layer on a side of the substrate film.

12. A protective sheet for a solar cell, comprising the gas barrier laminate film according to any one of claims 1 to 11.

13. A protective sheet for a liquid crystal display device, comprising the gas barrier laminate film according to any one of claims 1 to 11.

14. A protective sheet for an organic device, comprising the gas barrier laminate film according to any one of claims 1 to 11.

15. A protective sheet for a vacuum heat insulator, comprising the gas barrier laminate film according to any one of claims 1 to 11.

16. A method for producing a gas barrier laminate film, comprising forming one layer or plural layers of an inorganic thin film layer on at least one surface of a substrate film, a first layer of the inorganic thin film layer on a side of the substrate film being formed by a facing target sputtering method.

17. The method for producing a gas barrier laminate film according to claim 16, wherein the gas barrier laminate film is one according to any one of claims 2 to 11.

Fig. 1

**INTERNATIONAL SEARCH REPORT**

| International application No. |
| --- |
| PCT/JP2012/058477 |

A. CLASSIFICATION OF SUBJECT MATTER
*B32B9/00*(2006.01)i, *C23C14/34*(2006.01)i

According to International Patent Classification (IPC) or to both national classification and IPC

B. FIELDS SEARCHED

Minimum documentation searched (classification system followed by classification symbols)
B32B1/00-43/00, C08J7/04-7/06, C23C14/00-14/58

Documentation searched other than minimum documentation to the extent that such documents are included in the fields searched
Jitsuyo Shinan Koho        1922-1996   Jitsuyo Shinan Toroku Koho   1996-2012
Kokai Jitsuyo Shinan Koho   1971-2012   Toroku Jitsuyo Shinan Koho   1994-2012

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X<br>Y | JP 6-238805 A  (Japan Synthetic Rubber Co., Ltd.),<br>30 August 1994 (30.08.1994),<br>example 1; paragraph [0016]<br>(Family: none) | 1-4,8-17<br>5-7 |
| X<br>Y | JP 2001-335926 A  (The Nippon Synthetic Chemical Industry Co., Ltd.),<br>07 December 2001 (07.12.2001),<br>examples 1, 12, 13; fig. 1<br>(Family: none) | 1-4,8-17<br>5-7 |
| Y | JP 2003-340971 A  (Dainippon Printing Co., Ltd.),<br>02 December 2003 (02.12.2003),<br>claims 1, 3, 9<br>(Family: none) | 5-7 |

☒  Further documents are listed in the continuation of Box C.          ☐  See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>   08 May, 2012 (08.05.12) | Date of mailing of the international search report<br>   22 May, 2012 (22.05.12) |
| --- | --- |
| Name and mailing address of the ISA/<br>   Japanese Patent Office | Authorized officer |
| Facsimile No. | Telephone No. |

Form PCT/ISA/210 (second sheet) (July 2009)

**17**

**INTERNATIONAL SEARCH REPORT**

International application No.

PCT/JP2012/058477

C (Continuation).    DOCUMENTS CONSIDERED TO BE RELEVANT

| Category* | Citation of document, with indication, where appropriate, of the relevant passages | Relevant to claim No. |
|---|---|---|
| A | JP 2682124 B2 (Toppan Printing Co., Ltd.),<br>26 November 1997 (26.11.1997),<br>claims<br>(Family: none) | 1-17 |

Form PCT/ISA/210 (continuation of second sheet) (July 2009)

**EP 2 692 520 A1**

**REFERENCES CITED IN THE DESCRIPTION**

**Patent documents cited in the description**

- JP 3319164 B
- JP 2006096046 A
- JP 6210790 A
- JP 2009101548 A
- JP 2007023304 A